Europäisches Patentamt

European Patent Office

Office européen des brevets

(19)

(11) Veröffentlichungsnummer : **0 060 975**
**B1**

(12) **EUROPÄISCHE PATENTSCHRIFT**

(45) Veröffentlichungstag der Patentschrift :
15.05.85

(51) Int. Cl.⁴ : **B 64 G   1/44, H 01 L 25/04**

(21) Anmeldenummer : **82100547.7**

(22) Anmeldetag : **27.01.82**

(54) **Solarzellen-Trägermembran.**

(30) Priorität : 17.03.81 DE 3110302

(43) Veröffentlichungstag der Anmeldung :
29.09.82 Patentblatt 82/39

(45) Bekanntmachung des Hinweises auf die Patenterteilung : 15.05.85 Patentblatt 85/20

(84) Benannte Vertragsstaaten :
FR GB IT

(56) Entgegenhaltungen :
RAUMFAHRTFORSCHUNG, Band 12, Nr. 3,
Juli/September 1968, Seiten 138-142, K. MARTINEZ et
al.: "Technology of large (1kW to 5kW) solar arrays"
6TH I.E.E.E. PHOTOVOLTAIC SPECIALIST'S CONF.
1967, Seiten 210-219 L. LYLE McMAHAN et al.:
"Cadmium-sulfide solar cells in a deployable array
composed of rigid frames"

(73) Patentinhaber : **Messerschmitt-Bölkow-Blohm Gesellschaft mit beschränkter Haftung
Robert-Koch-Strasse
D-8012 Ottobrunn (DE)**

(72) Erfinder : **Bansemir, Horst, Dr.
Geitnerweg 4
D-8000 München 82 (DE)**
Erfinder : **Buchs, Wolfgang, Dipl.-Ing.
Graf-Arco-Strasse 4
D-8151 Valley (DE)**

**Beschreibung**

Die Erfindung betrifft eine Solarzellen-Trägermembran, die in einem Rahmen an zwei einander gegenüberliegenden Seiten elastisch eingespannt ist und aus einer mit einem Gewebe aus faserverstärktem Kunststoff belegten Kunststoffolie besteht.

Eine derartige Träger-Membran ist beispielsweise aus der DE-A-29 23 535 bekannt. Sie besteht aus einer 25 μm starken Polyimidfolie, die mit einem faserverstärkten Kunststoff, nämlich einem Carbonfasergewebe, verstärkt ist. Die Membran ist an zwei gegenüberliegenden Seiten mit Hilfe von Tellerfederpaketen in einem aus Faserverbundwerkstoff bestehenden Rahmen eingespannt. Die Anordnung findet bei Solargeneratoren für Raumflugkörper Anwendung. Die flächenhaften Solarzellen sind auf der dem Carbonfasergewebe abgewandten Seite der Kunststoffolie aufgebracht.

An Solarzellen-Trägermembranen, die beispielsweise bei Synchronsatelliten verwendet werden, um deren Stromversorgung zu sichern, sind verschiedene Anforderungen zu stellen. Aus Gründen der Gewichtsersparnis sollen sie einerseits möglichst leicht sein, andererseits ist eine gewisse mechanische Stabilität unabdingbar. Da bei Umlaufbahnen etwa im Äquatorbereich aufgrund der ständig sich wiederholenden Abschattung durch die Erde starke Temperaturdifferenzen auftreten, muß die Anordnung weiterhin so ausgebildet sein, daß keine zu starken Spannungen zwischen Rahmen und Membran auftreten. Die Rahmen werden daher häufig aus carbonfaserverstärktem Kunststoff gefertigt, da dieser einen verhältnismäßig geringen thermischen Ausdehnungskoeffizienten besitzt. Zwar wird mit dem Carbonfasergewebe zur Verstärkung der Kunststoffolie ein gleichartiges Material verwendet, jedoch ist der thermische Ausdehnungskoeffizient des speziell eingesetzten Fasertyps immer noch um so viel höher als der des Rahmenmaterials, daß thermisch bedingte Spannungen noch in erheblichem Ausmaß auftreten. Weiterhin ist zu beachten, daß die als Unterlage für die Solarzellen dienende Kunststoffolie eine ausreichende Isolationswirkung bieten muß, was bei Verwendung des elektrisch leitfähigen Carbonfasergewebes eine gewisse Mindestdicke der Kunststoffolie voraussetzt. Es besteht somit ein Bedürfnis, die genannten Anforderungen auf technisch und wirtschaftlich noch bessere Weise zu erfüllen.

Der Erfindung liegt daher die Aufgabe zugrunde, eine Solarzellen-Trägermembran der eingangs genannten Art bereitzustellen, die insbesondere durch Reduzierung der erforderlichen Masse, der auftretenden thermischen Spannungen sowie des mit des Isolation verbundenen Material- und Prüfungsaufwandes hinsichtlich der Wirtschaftlichkeit und der Betriebszuverlässigkeit eine Verbesserung der bekannten Anordnung darstellt.

Diese Aufgabe wird gemäß der Erfindung dadurch gelöst, daß das Gewebe aus kreuzweise verwobenen, einmal in der durch die beidseitige Einspannung gegebenen Vorzugsrichtung und zum anderen im wesentlichen quer dazu verlaufenden Bändern aus aramidfaserverstärktem Kunststoff gebildet wird und der Grad der Flächenbelegung für die in der Vorzugsrichtung verlaufenden Bänder höher ist als für die im wesentlichen quer dazu verlaufenden Bänder.

Mit der erfindungsgemäßen Gestaltung der Träger-Membran ist zunächst eine erhebliche Herabsetzung der thermisch bedingten Spannungen verbunden. So beträgt der thermische Ausdehnungskoeffizient der Bänder auf der Basis der Aramidfaser lediglich noch ca. $1{,}3 \cdot 10^{-6}$ $K^{-1}$ gegenüber einem Wert von ca. $3{,}5 \cdot 10^{-6}$ $K^{-1}$ des Carbonfasergewebes. Die Differenz gegenüber dem thermischen Ausdehnungskoeffizienten des Rahmens, der im Falle von carbonfaserverstärktem Kunststoff ca. $0{,}1 \cdot 10^{-6}$ $K^{-1}$ beträgt, wird also erheblich verringert. Außerdem weist die Aramidfaser mit ca. 2 830 N/mm auch einen deutlich geringeren Wert für die Dehnsteifigkeit auf, die beim Carbonfasergewebe ca. 4 100 N/mm beträgt. Das Ausmaß der thermisch bedingten Spannungen wird durch die erfindungsgemäße Maßnahme demnach erheblich herabgesetzt. Weiterhin ist von günstigem Einfluß, daß die Aramidfaser elektrisch nicht leitend ist, so daß die Polyimidfolie keine elektrisch isolierende Wirkung mehr zu haben braucht. Ihre Stärke kann damit auf weniger als die Hälfte herabgesetzt werden, wodurch sich bereits eine gewisse Gewichtsverminderung ergibt.

Die Masse kann dadurch noch weiter verringert werden, daß der Flächenbelegungsgrad der im wesentlichen quer zur Vorzugsrichtung verlaufenden Bänder so weit wie möglich reduziert wird. Die Vorzugsrichtung ergibt sich als Verbindung zwischen den beiden einander gegenüberliegenden Seiten, an denen die Membran eingespannt ist. In dieser Richtung verlaufen die Spannungen, die sich unvermeidlich aufgrund der immer noch vorhandenen unterschiedlichen thermischen Ausdehnung zwischen Rahmen und Membran ergeben. Deshalb ist es erforderlich, die Kunststoffolie vor allem in dieser Richtung mit Hilfe der aufgebrachten Bänder zu verstärken. Der auf die Vorzugsrichtung bezogene Flächenbelegungsgrad, d. h. der Flächenanteil der Folie, der mit den in dieser Richtung verlaufenden Bändern belegt ist, darf also einen gewissen, von der jeweiligen Belastung abhängigen Mindestwert nicht unterschreiten. Hingegen kann der Flächenbelegungsgrad in der Querrichtung erheblich niedriger sein. Dies bedeutet beispielsweise unter der Voraussetzung, daß Bänder gleicher Breite verwendet werden, daß die in der Vorzugsrichtung verlaufenden Bänder nahezu direkt nebeneinander angeordnet werden können, während die quer dazu gerichteten Bänder größere Abstände voneinander aufweisen. Im Gegensatz zu dieser Ausführung wurden die bisher verwendeten Verstärkungsgewebe hinsichtlich beider Richtungen gleichberechtigt gestaltet. Aus der erfindungsgemäßen Reduzierung der Anzahl der Querbänder bzw. des auf die Querrichtung bezogenen Flächenbelegungsgrades ergibt sich eine entsprechende weitere Massenverminderung.

Unter dem Begriff « Flächenbelegung » soll hier auch verstanden werden, daß die Bandstärke zu berücksichtigen ist, so daß bei gleicher Bandbreite und gleichem Bandabstand die Flächenbelegung mit steigender Bandstärke proportional anwächst.

Gegen den Einsatz der Aramidfaser für den erfindungsgemäßen Zweck bestanden zunächst erhebliche Bedenken, da angenommen wurde, daß die Materialeigenschaften unter Weltraumbedingungen, insbesondere aufgrund der UV-Strahlung, eine unzulässige Degradation erfahren Würde. Es wurde davon ausgegangen, daß die Polymerstruktur der Aramidfaser sich unter dem Einfluß der Strahlung zersetzen und die mechanische Festigkeit der Faser damit auf unannehmbare Weise herabgesetzt würde. Wider Erwarten wurde jedoch gefunden, daß dieser Effekt unter Bedingungen, die den in einer Erdumlaufbahn herrschenden Strahlungsbedingungen vergleichbar sind, nicht in dem befürchteten Ausmaß auftritt, wenn die der Strahlung abgewandte Seite der Polyimidfolie mit dem Gewebe aus aramidfaserverstärktem Kunststoff belegt wird.

In den beiden Abbildungen sind zwei Ausführungsbeispiele der Erfindung in schematischer Weise dargestellt.

Figur 1 zeigt in Draufsicht einen Teil einer Membran mit senkrecht zueinander verlaufenden Bändern gleicher Breite ;

Figur 2 zeigt in Draufsicht eine Membran mit Bändern ungleicher Breite, wobei die im wesentlichen quer zur Vorzugsrichtung verlaufenden Bänder auch eine Komponente in dieser Richtung aufweisen.

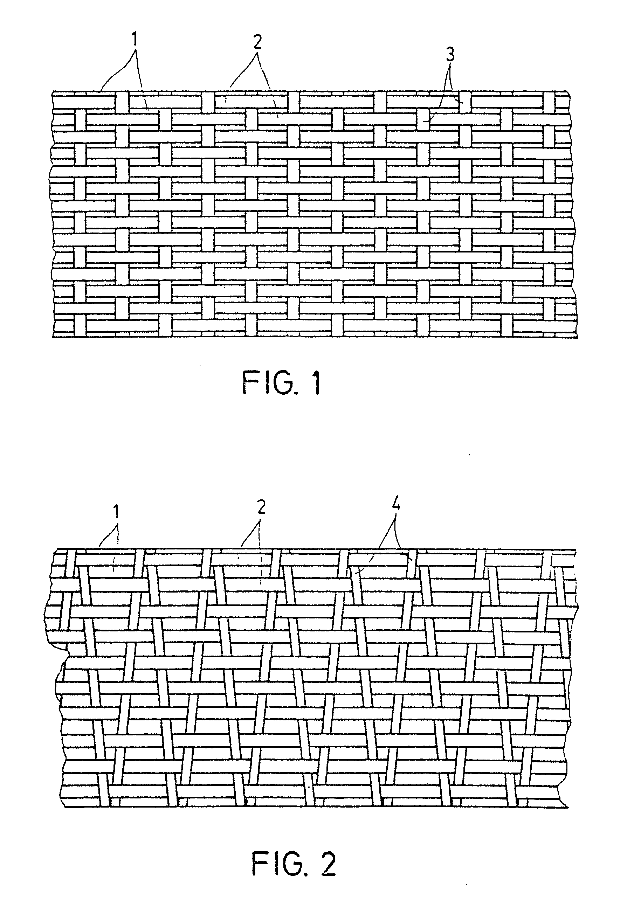

Der vorzugsweise rechteckige Rahmen, in den die Membran eingespannt ist, ist in beiden Fällen nicht dargestellt. Auf einer Kunststoffolie 1, vorzugsweise einer Polyimidfolie, ist ein Gewebe aus faserverstärktem Kunststoff aufgebracht, vorzugsweise durch Verkleben. Das Gewebe besteht aus in der Vorzugsrichtung verlaufenden Bändern 2 sowie im Falle der Fig. 1 aus kreuzweise mit letzteren verwoben und senkrecht zu diesen verlaufenden Bändern 3 gleicher Breite, im Falle der Fig. 2 aus schräg, jedoch im wesentlichen quer zur Vorzugsrichtung verlaufenden Bändern 4 geringerer Breite. Die Bänder 2, 3 und 4 bestehen aus aramidfaserverstärktem Kunststoff. Wie die beiden Abbildungen zeigen, sind sowohl hinsichtlich der Bänderbreite als auch bezüglich des gegenseitigen Abstandes sowie der Richtung Variationsmöglichkeiten gegeben, die im Rahmen der Erfindung liegen. Wesentlich ist neben der Materialauswahl, daß der Flächenbelegungsgrad bei den im wesentlichen quer zur Vorzugsrichtung verlaufenden Bändern geringer ist als bei den in Vorzugsrichtung verlaufenden Bändern. So beträgt im Falle der Fig. 1 der Flächenbelegungsgrad der Bänder 2 etwa 0,75 und derjenige der Bänder 3 etwa 0,3. Der Flächenbelegungsgrad der in Vorzugsrichtung verlaufenden Bänder übersteigt den der quergerichteten Bänder damit um einen Faktor von 2,5. Im Falle der Fig. 2 beträgt der Flächenbelegungsgrad der Bänder 2 etwa 0,5 sowie derjenige der Bänder 4 etwa 0,25, woraus sich ein Faktor von etwa 2,0 ergibt. Im Prinzip sollte dieser Faktor möglichst hoch sein, wobei letztlich ein Kompromiß zwischen abnehmender Masse und gleichzeitig abnehmender Festigkeit der Membran zu schließen ist.

**Patentanspruch**

Solarzellen-Trägermembran, die in einem Rahmen an zwei einander gegenüberliegenden Seiten elastisch eingespannt ist und aus einer mit einem Gewebe aus faserverstärktem Kunststoff belegten Kunststoffolie (1) besteht, dadurch gekennzeichnet, daß das Gewebe aus kreuzweise verwobenen, einmal in der durch die beidseitige Einspannung gegebenen Vorzugsrichtung und zum anderen im wesentlichen quer dazu verlaufenden Bändern (2 ; 3, 4) aus aramidfaserverstärktem Kunststoff gebildet wird und der Grad der Flächenbelegung für die in der Vorzugsrichtung verlaufenden Bänder (2) höher ist als für die im wesentlichen quer dazu verlaufenden Bänder (3, 4).

**Claim**

A solar-cell carrier membrane which is clamped elastically at two mutually opposite sides in a frame and which consists of a plastics foil (1) which is covered with a fabric made of fibre-reinforced plastics material, characterised in that the fabric is formed from bands (2 ; 3, 4) made of aramide-fibre-reinforced plastics material which are interwoven in a crosswise manner and which extend on the one hand in the preferred direction afforded by the clamping on both sides and on the other hand substantially transversely thereto and the extent of the surface covering for the bands (2) extending in the preferred direction is higher than for the bands (3, 4) extending substantially transversely thereto.

**Revendication**

Membrane support pour cellule solaire, qui est tendue d'une façon élastique dans un cadre sur deux côtés opposés l'un à l'autre et qui est constituée par une feuille de matière synthétique revêtue d'un tissu en matière synthétique renforcée par des fibres, caractérisée par le fait que le tissu est formé par des bandes (2 ; 3, 4) tissées en croix, se développant d'une part dans la direction préférentielle donnée par la tension de chaque côté et d'autre part dans la direction essentiellement perpendiculaire à celle-ci, qui sont en matière synthétique renforcée par des fibres d'aramide, et que le degré de recouvrement superficiel pour les bandes (2) se développant dans la direction préférentielle est supérieur à celui des bandes (3, 4) se développant dans la direction essentiellement perpendiculaire à celle-ci.

FIG. 1

FIG. 2